# EUROPEAN PATENT SPECIFICATION

(11) **EP 1 082 883 B1**
(45) Date of publication and mention of the grant of the patent: **16.10.2002**
(21) Application number: 99955387.8
(22) Date of filing: 27.05.1999
(51) Int. Cl.: H05K 3/00, B23K 26/06, B23K 26/00

(54) **APPARATUS AND METHOD FOR DRILLING MICROVIA HOLES IN ELECTRICAL CIRCUIT INTERCONNECTION PACKAGES**
VORRICHTUNG UND VERFAHREN ZUR PERFORIERUNG VON MIKROVIA-LÖCHERN IN VERPACKUNGEN VON ELEKTRISCHEN VERBINDUNGSSTELLEN VON ELEKTRISCHEN SCHALTUNGEN
DISPOSITIF PERMETTANT DE FORER DES TROUS D'INTERCONNEXION MICROSCOPIQUES DANS DES BLOCS DE CONNEXION DE CIRCUIT ELECTRIQUE ET TECHNIQUE AFFERENTE

(30) Priority: 29.05.1998 GB 9811557
(43) Date of publication of application: 14.03.2001
(73) Proprietor: Exitech Limited, Long Hanborough, Oxford OX8 8LH (GB); Excellon Automation Co., Torrance, California 90505 (US)
(72) Inventor: GOWER, Malcolm, Charles, Long Hanborough, Oxford OX8 8LH (GB); RUMSBY, Philip, Thomas, Long Hanborough, Oxford OX8 8LH (GB); THOMAS, Dafydd, Wyn, Long Hanborough, Oxford OX8 8LH (GB)
(74) Representative: Wagner, Karl H., Dipl.-Ing.
(86) International application number: GB9901694
(87) International publication number: WO99063793

(56) References cited:
- WO-A-97/46349
- WO-A-98/22252
- CA-A- 2 149 949
- FR-A- 2 044 303
- US-A- 5 362 940
- US-A- 5 702 662

## Description

This invention relates to an apparatus and method for drilling microvia holes in electrical circuit packages, and particularly to the use of shaped beams of laser radiation therein.

Pulsed lasers are being used increasingly to drill <150µm diameter microvia holes in a wide variety of electrical circuit packages. The most common material used to construct the conducting layer in printed circuit boards (PCB's) and printed wiring boards (PWBs) is copper. Dielectric insulating materials include resins, epoxies, phenolics, polyimides and polytetrafluoethylene sometimes containing embedded fibers of aramid, glass, silica or carbon to provide added reinforcing strength.

For the purposes of this invention, an *unshaped* beam of laser radiation is defined as having a spatial intensity distribution in a plane normal to its propagation direction similar in shape but not in size to that produced directly by the laser radiation source. Normally unshaped beams refer to full or aperture truncated versions of Gaussian-type distributions as produced when lasers operate in their lowest order TEM₀₀ transverse mode. A *shaped* beam is defined as having a spatial intensity distribution which has been deliberately redistributed from the unshaped beam by for example the use of optical elements.

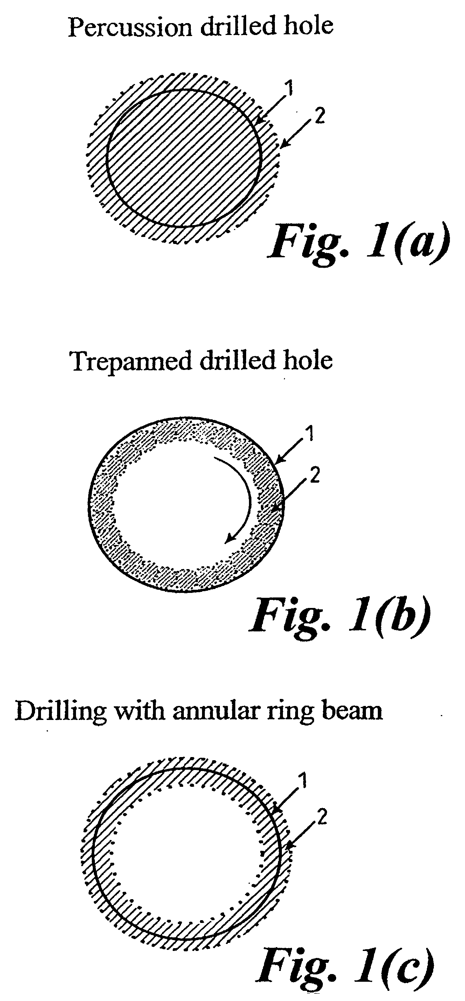

Current laser-based tools designed to drill microvia holes in both metal and dielectric layers of circuit boards incorporate neodymium (Nd) lasers operating at fundamental or harmonic wavelengths of 1.06µm, 355nm or 266nm with near-Gaussian unshaped spatial intensity distributions. As illustrated in Figure 1, microvias are laser drilled either in a punching mode (Figure 1(a)) whereby the focal spot of the laser beam (2) determines the diameter of the drilled hole (1), or in a trepanning mode (Figure 1(b)) whereby the focal spot (2) is made smaller than the hole (1) and is then moved in a circular, elliptical or spiral motion defining the hole diameter (1). The trepanning method is preferred because the hole diameter can be programmed to have different sizes across a single board. Also trepanned holes tend to produce a better quality edge than punched ones. To define the microvia position, diameter and trepanning motion, such tools employ computer-controlled moving-magnet galvanometer mirrors to position with high speed and accuracy the focused laser beam on a subfield of the board. Larger drilled areas are obtained by joining these scanning subfields together with precision motorized tables that position the board underneath the beam. Currently there is great commercial interest in seeking ways to improve the performance of such microvia drilling tools in terms of increasing their speed, productivity and the quality of hole they produce. A more detailed understanding of the performance limitations of existing microvia laser-drilling tools is required before introducing the subject of this invention.

If drilling proceeds at the same depth per pulse, a trepanned hole will require at least 2π(R-1) more pulses to drill than a punched one - where R is a ratio of the drilled hole to laser focal spot diameter. Hence with a laser operating under similar conditions, drill speeds are generally much slower for trepanned holes. To compensate for this slower rate, lasers operating at very high pulse repetition rates (>2kHz) are generally used to provide in the shortest time possible the many additional pulses required for drilling trepanned holes. Speeds are then limited by the maximum average power which can be delivered at such high rates by the laser source. In the ultraviolet spectral region average powers from CW pumped Q-switched Nd lasers operating at multi-kilohertz pulse repetition rates are limited to a few watts. Depending on material type and thickness, hole diameter and pitch, maximum speeds for drilling trepanned holes in both metal and dielectric layers in standard board constructions are currently limited to <100 holes/sec.

US 5 362 940 discloses an apparatus and method for material processing including drilling microvia holes in electrical packages. The apparatus comprises a laser radiation source emitting a beam of laser radiation and beam shaping elements, including a Fresnel zone plate array, which act to shape the spatial intensity distribution of the beam.

WO 98/22252 discloses a number of methods and apparatus for laser drilling via holes in printed wiring boards (PWBs). This invention is mainly directed towards positioning of the PWBs with respect to the laser radiation.

According to a first aspect of the present invention there is provided a laser drilling tool for drilling microvia holes in electrical interconnection packages, comprising a laser radiation source emitting a beam of laser radiation and beam shaping elements which act to shape the spatial intensity distribution of the beam, wherein the intensity distribution of the beam is shaped to be annular.

The use of beam shaping elements improves the speed and productivity of tools used to laser drill microvia holes in PCB's, PWB's and other electrical interconnection packages. Suitably designed beam shaping elements allow more effective use to be made of the available laser power for drilling high quality holes.

The beam shaping elements may be optical elements. The beam shaping elements may be extrinsic to the laser source or intrinsic to the laser source.

Optical components such as spherically aberrating and aspheric lenses, multifaceted mirrors, segmented lens arrays, phase and zone plates, axicons, kineforms, diffractive and holographic optical elements (DOE's and HOE's) may be used to shape the spatial intensity distribution of the beam.

The beam shaping elements may act to shape the beam of laser radiation to form an annular array of smaller beamlets.

The annular intensity distribution may have an annulus having a width of less than or equal to 10% of the diameter of the distribution.

As illustrated in Figure 1(c), the simplest beam shape which can be used for improving hole drilling speeds is one having an annular intensity distribution (2). In analogy to a 'pastry-cutter' or 'hole-saw' which cuts only around a circumference, so an annular beam cuts without delivering energy to the full area of the hole (1) being drilled. Hence because the laser is required to remove much less material from the hole, drilling speeds can be greatly enhanced or lasers delivering much smaller pulse energies can be used to achieve similar cutting speeds to punched holes. On the other hand since fewer pulses are required for shaped beam drilling, lower pulse repetition rates sources can be used than for trepan drilling. If shaping is carried out without energy loss, the ratio of the full hole to shaped beam area on the workpiece provides an estimate of the increase to the drilling speed or the reduction of laser power which can be achieved. This invention allows the use of lower repetition rate laser sources without compromising the speed for drilling different size microvias on a single board. By incorporating efficient beam shaping elements delivering optimized intensity profiles in tools used for laser drilling microvia holes, the maximum drill speed can be made several times faster than when drilling with unshaped beams.

Another limitation of current laser drilling machines is the difficulty in some materials of producing cleanly cut microvia holes which have adequate quality for subsequent metal plating processes. After assembly, plating flaws down the microvia can lead to lack of electrical continuity from the conducting layer above to the one below. It is known when drilling or cutting material with pulsed lasers having Gaussian-like intensity distributions that spatially slowly taper to zero intensity, the definition of the hole or cut can be poor. The beam shaping elements may act to shape the beam of laser radiation to have an intensity distribution which tapers to zero intensity more rapidly than a Gaussian-like intensity distribution. By incorporating beam shaping elements to produce optimized intensity profiles, the edge definition of holes produced by microvia laser drilling tools can be made superior to that produced by drilling with unshaped beams.

Crucial to the success of drilling with shaped beams is the ability to convert with minimal energy loss the laser radiation source output intensity distribution into the distribution required. The beam shaping elements preferably act to convert the output intensity distribution of the laser radiation source to the required intensity distribution with an energy conversion efficiency exceeding 50%. The beam shaping elements used to achieve this energy conversion efficiency may be conical (axicon)-spherical lens combinations and/or DOE's. Although such conversion is achieved only at a particular plane rather than in a collimated beam, drilling with shaped laser beams can be achieved by focusing or imaging onto the package surface with a suitable demagnifying lens. The beam shaping elements may comprise an f-theta lens to produce a focal spot having a shaped intensity distribution on the surface of the package.

The f-theta lens may have a focal length of 100mm. F-theta lenses are normally used in combination with galvanometer beam scanning mirrors to provide an unshaped focused beam at normal incidence over a wide area of a package. The f-theta lens of the laser drilling tool may be used to produce a focal spot over a similar wide area of the package.

The laser drilling tool may comprise a set of beam shaping elements incorporated into a single mask-type element. The mask-type element is preferably used to drill holes of different diameters in a package. The mask-type element may comprise a 4 inch (10.16cm) square fused silica transmissive mask plate containing twelve or more DOE's each producing at the same plane an annular beam having a different diameter. The lateral position of the mask-type element in the beam of laser radiation may be computer-controlled for example the position may be CNC controlled using z-y motorised stages.

The laser radiation source may operate on a high order transverse spatial mode. The laser radiation source may comprise a TEM₀₀ mode Q-switched neodymium laser. This may operate at fundamental, 2nd or 3rd-harmonic wavelengths of 1.06µm, 533nm or 355nm respectively. This may produce several watts average power at pulse repetition frequencies up to 20kHz.

According to a second aspect of the present invention there is provided a method of drilling microvia holes in electrical interconnection packages using a laser drilling tool according to the first aspect of the invention.

The method may comprise drilling microvia holes using a punching or a trepanning drilling method. The method may comprise drilling microvia holes which are circular or which are non-circular for example elliptical, rectangular or square.

A beam shaped to form of an annular array of smaller beamlets may prove to be better suited for microvia drilling and so is encompassed by the invention. Also the invention is not specific to the method used to shape the beam. The invention encompasses the use of beam shaping elements designed for the purposes of improving the performance of microvia laser drilling tools and which may be located both extrinsic and intrinsic to the laser source. For example, an incorporated laser radiation source designed specifically to operate on a high order transverse spatial mode for the purpose of improving the performance of the microvia drilling tool is encompassed. The invention is not restricted to the incorporation of beam shaping for use only with one microvia hole drilling method and so encompasses the use of shaped beams for improving the drilling performance of microvia laser drilling tools which use both the punching and trepanning drilling methods. Furthermore, it is not restricted to the drilling of a specific hole shape and so encompasses the use of shaped beams to improve the performance of tools designed to laser drill non-circular (e.g. elliptical, rectangular, square, etc) microvia holes.

An embodiment of the present invention will now be described by way of example only, with reference to the accompanying drawings, in which:
**Figure 1 (a), (b) and (c)** shows microvia holes drilled in a punching mode, a trepanning mode and using an annular beam, respectively, and
**Figure 2** shows a laser drilling tool according to the first aspect of the invention.

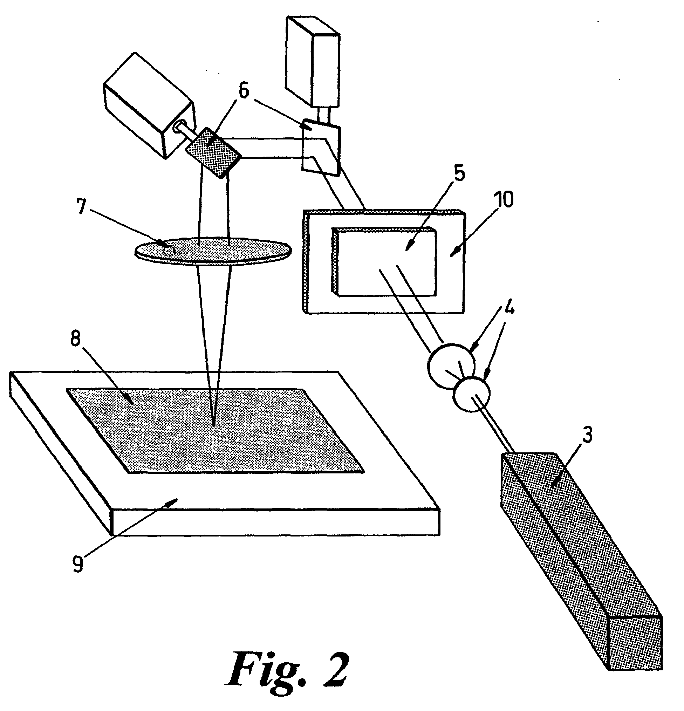

Figure 2 shows a laser drilling tool incorporating a DOE (5) designed to produce a beam of laser radiation having an annular distribution of intensity which within the ring has a uniform constant intensity. The width of the annulus may typically be ≤10% of its diameter. The unshaped beam from a TEM₀₀ mode Q-switched Nd laser (3) operating at its fundamental, 2nd or 3rd-harmonic wavelengths of 1.06µm, 533nm, 355nm and producing several watts average power at pulse repetition frequencies up to 20kHz is used as the radiation source. Computer-controlled galvanometer scanning mirrors (6) are used to position the beam at speeds up to 30m/sec over a 50x50mm subfield on the board (8) being drilled. Complete boards up to the 650x650mm size are drilled by moving the panel with CNC controlled motorized tables (9) underneath the beam and drilling each subfield with the scanning beam. The DOE (5) that produces the annular beam can be manufactured by etching a fused silica substrate with the diffractive structures defined by lithographic methods. The size of the DOE need only be slightly larger than the beam after it has passed through the beam expanding telescope (4), say between 10 - 18mm diameter. To provide different diameter hole sizes on the PCB, one 4" (10.16cm) square fused silica transmissive 'mask' plate containing twelve or more DOE's can be made so each produces at the same plane an annular beam having a different diameter matched to cover the range of hole sizes required to be drilled. The lateral positioning of the DOE mask in the beam and hole size selection can be CNC controlled using z-y motorized stages (10). An f-theta scanning lens (7) typically of 100mm focal length is used to produce on the surface of the board (8) a focal spot having the annular intensity distribution produced by the DOE (5). Depending on material type and thickness, hole diameter and pitch, such a tool is capable of drilling microvia holes at rates exceeding 200 holes/sec in PCB's and PWB's of standard construction. This represents approximately a four-fold improvement of drilling speed compared to a similar laser machine not incorporating any beam shaping elements. By designing the DOE to produce a near uniform intensity within the illumination ring, the sharp outer edge of the distribution provides wall definition of the hole which is superior to that produced when drilling with unshaped distributions.

## Claims

1. A laser drilling tool for drilling microvia holes in electrical interconnection packages (8), comprising a laser radiation source (3) emitting a beam of laser radiation and beam shaping elements (5,7) which act to shape the spatial intensity distribution of the beam, **characterised in that** the intensity distribution of the beam is shaped to be annular.

2. A laser drilling tool according to claim 1 **characterised in that** the beam shaping elements (5,7) are optical elements.

3. A laser drilling tool according to claim 1 or claim 2 **characterised in that** the beam shaping elements (5, 7) are extrinsic to the laser source (3).

4. A laser drilling tool according to claim 1 or claim 2 **characterised in that** the beam shaping elements (5, 7) are intrinsic to the laser source (3).

5. A laser drilling tool according to any preceding claim **characterised in that** the beam shaping elements (5, 7) act to shape the beam of laser radiation to form an annular array of smaller beamlets.

6. A laser drilling tool according to claim 1 **characterised in that** the annular intensity distribution has an annulus having a width of less than or equal to 10% of the diameter of the distribution.

7. A laser drilling tool according to any preceding claim **characterised in that** the beam shaping elements (5, 7) act to convert the output intensity distribution of the laser radiation source (3) to the required intensity distribution with an energy conversion efficiently exceeding 50%.

8. A laser drilling tool according to claim 7 **characterised in that** the beam shaping elements (5, 7) are conical (axicon)-spherical lens combinations and/or diffractive optical elements.

9. A laser drilling tool according to any preceding claim **characterised in that** the beam shaping elements (5, 7) comprise an f-theta lens (7) to produce a focal spot having a shaped intensity distribution on the surface of the package (8).

10. A laser drilling tool according to claim 9 **characterised in that** the f-theta lens (7) has a focal length of 100mm.

11. A laser drilling tool according to any preceding claim **characterised in that** the tool comprises a set of beam shaping elements incorporated into a single mask-type element.

12. A laser drilling tool according to claim 11 **characterised in that** the mask-type element is used to drill holes of different diameters in a package.

13. A laser drilling tool according to claim 11 or claim 12 **characterised in that** the mask-type element comprises a 4" (10.16cm) square fused silica transmissive mask plate containing twelve or more diffractive optical elements each producing at the same plane an annular beam having a different diameter.

14. A laser drilling tool according to any of claims 11 to 13 **characterised in that** the position of the mask-type element in the laser beam is computer-controlled.

15. A laser drilling tool according to any preceding claim **characterised in that** the laser radiation source (3) operates on a high order transverse spatial mode.

16. A laser drilling tool according to any preceding claim **characterised in that** the laser radiation source (3) comprises a TEM₀₀ mode Q-switched neodymium laser.

17. A method of drilling microvia holes in electrical interconnection packages **characterised in that** the method uses a laser drilling tool according to any of claims 1 to 16.

18. A method according to claim 17 **characterised by** using a punching drilling method.

19. A method according to claim 17 **characterised by** using a trepanning drilling mode.

20. A method according to any of claims 17 to 19 **characterised by** drilling circular microvia holes.

21. A method according to any of claims 17 to 19 **characterised by** drilling non-circular microvia holes, for example elliptical, rectangular or square microvia holes.

## Patentansprüche

1. Ein Laser-Bohrwerkzeug zum Bohren von Microvia-Löchern in elektrischen Verbindungsstellen oder Verbindungspackungen (8), wobei folgendes vorgesehen ist:
Eine Laserstrahlungsquelle (3), die einen Strahl von Laserstrahlung aussendet und Strahlformungselemente (5, 7), die bewirken, dass die räumliche Intensitätsverteilung des Strahls geformt wird, **dadurch gekennzeichnet, dass** die Intensitätsverteilung des Strahls ringförmig geformt wird.

2. Ein Laser-Bohrwerkzeug nach Anspruch 1, **dadurch gekennzeichnet, dass** die Strahlformelemente (5, 7) optische Elemente sind.

3. Ein Laser-Bohrwerkzeug nach Anspruch 1 oder 2, **dadurch gekennzeichnet, dass** die Strahlformelemente (5, 7) extrinsisch, d. h. außerhalb der Laserquelle angeordnet sind.

4. Ein Laser-Bohrwerkzeug nach Anspruch 1 oder 2, **dadurch gekennzeichnet, dass** die Strahlformungselemente (5, 7) intrinsisch, d. h. innerhalb der Laserquelle, vorgesehen sind.

5. Ein Laser-Bohrwerkzeug nach einem vorherigen Anspruch, **dadurch gekennzeichnet, dass** die Laserformelemente (5, 7) die Formung des Strahls von Laserstrahlung zur Bildung einer ringförmigen Anordnung von kleineren Strahlen bewirken.

6. Ein Laser-Bohrwerkzeug nach Anspruch 1, **dadurch gekennzeichnet, dass** die ringförmige Intensitätsverteilung einen Ring aufweist, und zwar mit einer Breite, die kleiner ist als oder gleich 10% des Durchmessers der Verteilung.

7. Ein Laser-Bohrwerkzeug nach einem vorhergehenden Anspruch, **dadurch gekennzeichnet, dass** die Strahlformelemente (5, 7) bewirken, die Augangsintensitätsverteilung der Laserstrahlungsquelle (3) auf die erforderliche Intensitätsverteilung mit einer Energieumwandlung, die effizient die 50% übersteigt, umzuwandeln.

8. Ein Laser-Bohrwerkzeug nach Anspruch 7, **dadurch gekennzeichnet, dass** die Strahlformelemente (5, 7) konische (axicon-)sphärische Linsenkombinationen sind, und/oder brechende optische Elemente.

9. Ein Laser-Bohrwerkzeug nach einem vorhergehenden Anspruch, **dadurch gekennzeichnet, dass** die Strahlformelemente (5, 7) eine f-theta Linse (7) aufweisen, um einen Brennpunkt zu erzeugen mit einer geformten Intensitätsverteilung auf der Oberfläche der Packung (8).

10. Ein Laser-Bohrwerkzeug nach Anspruch 9, **dadurch gekennzeichnet, dass** die f-theta Linse (7) eine Brennweite von 100 mm besitzt.

11. Ein Laser-Bohrwerkzeug nach einem vorhergehenden Anspruch, **dadurch gekennzeichnet, dass** das Werkzeug einen Satz von Strahlformelementen aufweist, und zwar inkorporiert in ein Element der Einzelmaskenbauart.

12. Ein Laser-Bohrwerkzeug nach Anspruch 11, **dadurch gekennzeichnet, dass** das Element der Maskenbauart verwendet wird, um Löcher von unterschiedlichen Durchmessern in einer Packung zu bohren.

13. Ein Laser-Bohrwerkzeug nach Anspruch 11 oder 12, **dadurch gekennzeichnet, dass** das Element der Maskenbauart eine 4" (10,16 cm) quadratische, geschmolzene Silizium-Dioxyd Maskenplatte, die durchsichtig ist, aufweist, und zwar 12 oder mehr brechende optische Elemente enthaltend, wobei jedes an der gleichen Ebene einen ringförmigen Strahl mit einem unterschiedlichen Durchmesser erzeugt.

14. Ein Laser-Bohrwerkzeug nach einem der Ansprüche 11 bis 13, **dadurch gekennzeichnet, dass** die Position des Elements der Maskenbauart in dem Laserstrahl computergesteuert ist.

15. Ein Laser-Bohrwerkzeug nach einem vorhergehenden Anspruch, **dadurch gekennzeichnet, dass** die Laserstrahlungsquelle (3) auf einer transversalen Raum-Mode oder Betriebsart einer hohen Ordnung arbeitet.

16. Ein Laser-Bohrwerkzeug nach einem vorhergehenden Anspruch, **dadurch gekennzeichnet, dass** die Laserstrahlungsquelle (3) ein TEM₀₀ Mode Q-geschalteter Neodymium-Laser ist oder diesen aufweist.

17. Ein Verfahren zum Bohren von Microvia-Löchern in elektrischen Verbindungspackungen, **dadurch gekennzeichnet, dass** das Verfahren ein Laser-Bohrwerkzeug gemäß einem der Ansprüche 1 bis 16 verwendet.

18. Ein Verfahren nach Anspruch 17, **dadurch gekennzeichnet, dass** ein Stanz-Drill-Verfahren verwendet wird.

19. Ein Verfahren nach Anspruch 17, **dadurch gekennzeichnet, dass** eine Trepanning-Drill-Betriebsart verwendet wird.

20. Ein Verfahren nach einem der Ansprüche 17 bis 19, **dadurch gekennzeichnet, dass** kreisförmige Microvia-Löcher gebohrt werden.

21. Ein Verfahren gemäß einem der Ansprüche 17 bis 19, **dadurch gekennzeichnet, dass** nicht kreisförmige Microvia-Löcher gebohrt werden, beispielsweise elliptische, rechteckige oder quadratische Microvia-Löcher.

## Revendications

1. Outil de perçage laser pour percer des trous de microvias dans des cartes d'interconnexion électrique (8) comprenant une source de rayonnement laser (3) émettant un faisceau de rayonnement laser et des éléments de mise en forme de faisceau (5, 7) qui agissent pour mettre en forme la distribution d'intensité spatiale du faisceau, **caractérisé en ce que** la distribution d'intensité du faisceau est mise en forme pour être annulaire.

2. Outil de perçage laser selon la revendication 1, **caractérisé en ce que** les éléments de mise en forme de faisceau (5, 7) sont des éléments optiques.

3. Outil de perçage laser selon la revendication 1 ou 2, **caractérisé en ce que** les éléments de mise en forme de faisceau (5, 7) sont extrinsèques à la source laser (3).

4. Outil de perçage laser selon la revendication 1 ou 2, **caractérisé en ce que** les éléments de mise en forme de faisceau (5, 7) sont intrinsèques à la source laser (3).

5. Outil de perçage laser selon l'une quelconque des revendications précédentes, **caractérisé en ce que** les éléments de mise en forme de faisceau (5, 7) agissent pour mettre en forme un réseau annulaire de plus petits éléments de faisceau.

6. Outil de perçage laser selon la revendication 1, **caractérisé en ce que** la distribution d'intensité annulaire présente un anneau ayant une largeur inférieure ou égale à 10% du diamètre de la distribution.

7. Outil de perçage laser selon l'une quelconque des revendications précédentes, **caractérisé en ce que** les éléments de mise en forme de faisceau (5, 7) agissent pour convertir la distribution d'intensité de sortie de la source de rayonnement laser (3) en la distribution d'intensité requise avec un rendement de conversion d'énergie dépassant 50%.

8. Outil de perçage laser selon la revendication 7, **caractérisé en ce que** les éléments de mise en forme de faisceau (5, 7) sont des combinaisons de lentilles axio-sphériques coniques et/ou d'éléments optiques de diffraction.

9. Outil de perçage laser selon l'une quelconque des revendications précédentes, **caractérisé en ce que** les éléments de mise en forme de faisceau (5, 7) comprennent une lentille f-θ (7) pour produire une tache focale ayant une distribution d'intensité mise en forme sur la surface de la carte (8).

10. Outil de perçage laser selon la revendication 9, **caractérisé en ce que** la lentille f-θ (7) a une distance focale de 100 mm.

11. Outil de perçage laser selon l'une quelconque des revendications précédentes, **caractérisé en ce que** l'outil comprend un ensemble d'éléments de mise en forme de faisceau incorporés dans un élément unique de type masque.

12. Outil de perçage laser selon la revendication 11, **caractérisé en ce que** l'élément de type masque est utilisé pour percer des trous de diamètres différents dans une carte.

13. Outil de perçage laser selon la revendication 11 ou 12, **caractérisé en ce que** l'élément de type masque comprend une plaque de masque transmissive carrée en silice fondue de 4 pouces (10,16 cm) contenant douze éléments optiques de diffraction ou plus produisant chacun au niveau du même plan un faisceau annulaire ayant un diamètre différent.

14. Outil de perçage laser selon l'une quelconque des revendications 11 à 13, **caractérisé en ce que** la position de l'élément de type masque dans le faisceau laser est commandée par ordinateur.

15. Outil de perçage laser selon l'une quelconque des revendications précédentes, **caractérisé en ce que** la source de rayonnement laser (3) fonctionne sur un mode spatial transverse d'ordre élevé.

16. Outil de perçage laser selon l'une quelconque des revendications précédentes, **caractérisé en ce que** la source de rayonnement laser (3) comprend un laser au néodyme à commutation de facteur de qualité dans le mode TEM₀₀.

17. Procédé de perçage de trous de microvias dans des cartes d'interconnexion électrique, **caractérisé en ce que** le procédé utilise un outil de perçage laser selon l'une quelconque des revendications 1 à 16.

18. Procédé selon la revendication 17, **caractérisé en ce que** l'on utilise une méthode de perçage par poinçonnage.

19. Procédé selon la revendication 17, **caractérisé en ce que** l'on utilise un mode de perçage par trépan.

20. Procédé selon l'une quelconque des revendications 17 à 19, **caractérisé en ce que** l'on perce des trous de microvias circulaires.

21. Procédé selon l'une quelconque des revendications 17 à 19, **caractérisé en ce que** l'on perce des trous de microvias non circulaires, par exemple des trous de microvias elliptiques, rectangulaires ou carrés.
